(19) Europäisches Patentamt
European Patent Office
Office européen des brevets

(11) Publication number: **0 659 553 A1**

# (12) EUROPEAN PATENT APPLICATION

(21) Application number: **94119281.7**

(51) Int. Cl.[6]: **B32B 27/34**

(22) Date of filing: **07.12.94**

(30) Priority: **22.12.93 US 172296**

(43) Date of publication of application:
**28.06.95 Bulletin 95/26**

(84) Designated Contracting States:
**DE FR GB**

(71) Applicant: **E.I. DU PONT DE NEMOURS AND COMPANY**
**1007 Market Street**
**Wilmington**
**Delaware 19898 (US)**

(72) Inventor: **Sutton, Richard Frederich, Jr.**
**361 Meadow Lane**
**Circleville,**
**Ohio 43113 (US)**
Inventor: **Kanakarajan, Kuppusamy**
**344 Avon Court**
**Dublin,**
**Ohio 43017 (US)**

(74) Representative: **von Kreisler, Alek, Dipl.-Chem. et al**
**Patentanwälte**
**von Kreisler-Selting-Werner**
**Postfach 10 22 41**
**D-50462 Köln (DE)**

## (54) Coextruded multi-layer aromatic polyimide film and preparation thereof.

(57) A multi-layer polyimide film having excellent adhesion between the layers without using an adhesive, prepared by coextruding a layer of a first poly(amic acid) derived from the reaction of an aromatic tetracarboxylic dianhydride and an aromatic diamine and at least one layer of a second poly(amic acid) derived from the reaction of 4,4'-oxydiphthalic dianhydride and a (diaminophenoxy)benzene to form a self-supporting multi-layer poly(amic acid) film and heat-treating the multi-layer film to completely convert the poly(amic acid) layers to the multi-layer polyimide film. Optionally, the poly(amic acid) solutions may contain fine particles of an inorganic filler to enhance properties of the multi-layer film. The coextruded multi-layer polyimide film is used in the formation of single and double polyimide metal-clad laminates for use in flexible circuit applications.

EP 0 659 553 A1

## BACKGROUND OF THE INVENTION

The present invention relates to a multi-layer aromatic polyimide film prepared by coextruding at least two aromatic poly(amic acid) solutions to form a multi-layer aromatic polyimide film having two or more layers and which does not contain an adhesive or tie layer. Particularly preferred are coextruded multi-layer polyimide films comprising a polyimide film base layer and at least one heat-sealable layer of a polyimide derived from 4,4'-oxydiphthalic dianhydride and a (diaminophenoxy)benzene.

Aromatic polyimides generally exhibit outstanding heat resistance in comparison with other organic polymers and, additionally, have excellent mechanical properties, chemical resistance and electrical insulating properties. However, due to the intractability of such polyimides and because of the high temperature limitations of commercially available adhesives, attempts to prepare multi-layer polyimide films by directly bonding one polyimide film surface to another polyimide film surface have not been entirely satisfactory. For example, commercially available non-polyimide adhesives lack sufficient thermal stability, radiation resistance, or flexibility, for most end uses of the polyimide.

Multi-layered polyimide films can also be prepared by coating a base gel film structure of a poly(amic acid), or other polyimide precursor, with a poly(amic acid) solution and thereafter heat-treating the coated base film to completely convert the entire structure to a polyimide polymeric material. However, in many cases, the poly(amic acid) coating exhibits inferior adhesion to the polyimide base film.

European Patent Application 0 474 054, published on March 11, 1992, discloses a multi-layer polyimide film comprising an aromatic polyimide film base layer and at least one layer of a heat-sealable polyimide adhesive containing at least 30 mole % of repeating imide units derived from 4,4'-oxydiphthalic dianhydride and a (diaminophenoxy)benzene. The multi-layer polyimide is prepared by coating a solution of the poly-(amic acid) adhesive directly on a fully cured polyimide base film, or on a partially cured poly(amic acid) gel or green film and then curing to form the polyimide.

U.S. 3,505,168, issued to Dunphy et al on April 7, 1970, discloses a heat-sealable polyimide laminar structure having at least two layers wherein the polyimide of one layer is different from the polyimide of the other layer, prepared by coating a base polyimide layer with a layer of a poly(amic acid) precursor and heat-treating to completely convert the poly(amic acid) precursor to the polyimide.

U.S. 3,770,573, issued to Dunphy et al on November 6, 1973, discloses multi-layer polyimide structures wherein one non-heat-sealable polyimide layer is interdiffusionally bonded to a heat-sealable polyimide layer, prepared by coating at least one surface of a base gel film structure with a poly(amic acid) composition and converting the coated base film to a unitary polyimide film structure.

European Patent Application 0 431 636, published on June 12, 1991, discloses an extruded multi-layer polyimide film comprising at least one layer, having a thickness of not more than 10 micrometers, of an aromatic polyimide derived from an aromatic tetracarboxylic dianhydride and an aromatic diamine having two or more benzene rings and a base polyimide layer derived from biphenyltetracarboxylic dianhydride and a phenylene diamine, prepared by simultaneously extruding at least two aromatic poly(amic acid) solutions through an extrusion molding die to form a two or three-layer film. Multi-layer polyimide films prepared by coextruding a copoly(amic acid) adhesive containing repeating imide units derived from 4,4'-oxydiphthalic dianhydride and a (diaminophenoxy)benzene are not disclosed.

The invention process thus fulfills a need for a multi-layer aromatic polyimide film having excellent adhesion between the polyimide layers and which does not require the use of an adhesive between the layers.

## SUMMARY OF THE INVENTION

According to the present invention, there is provided a process for preparing a coextruded multi-layer aromatic polyimide film comprising the steps of:

(a) forming a first solution stream of an aromatic poly(amic acid) derived from the reaction of at least one aromatic tetracarboxylic dianhydride and at least one aromatic diamine dissolved in a polar organic solvent;

(b) forming a second solution stream of a poly(amic acid) derived from the reaction of from 30 to 100 mole % of 4,4'-oxydiphthalic dianhydride, from 0 to 30 mole % of an aromatic tetracarboxylic dianhydride selected from the group consisting of pyromellitic dianhydride, 3,3',4,4'-benzophenone tetracarboxylic dianhydride, 2,2',3,3'-benzophenone tetracarboxylic dianhydride, 3,3',4,4'-biphenyltetracarboxylic dianhydride, 2,2',3,3'-biphenyltetracarboxylic dianhydride, 2,2-bis(3,4-dicarboxyphenyl)-hexafluoropropane dianhydride, 2,2-bis(3,4-dicarboxyphenyl)sulfone dianhydride, 2,2-bis(3,4-dicarboxyphenyl)methane dianhydride, 2,2-bis(3,4-dicarboxyphenyl)propane dianhydride, and m-phenylene bis-

(trimellitate)dianhydride, from 30 to 100 mole % of a (diaminophenoxy)benzene of the formula

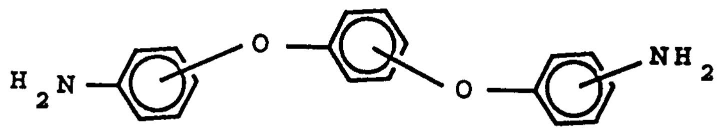

and from 0 to 30 mole % of a diamine selected from the group consisting of p-phenylene diamine, hexamethylene diamine, heptamethylene diamine, octamethylene diamine, 4,4'-diaminodiphenyl ether, 3,4'-diaminodiphenyl ether, 1,3-bis(4-aminobenzoyloxy)benzene, 4,4'-diaminobenzanilide, 4,4'-bis(4-aminophenoxy)phenyl ether and a polysiloxane diamine dissolved in said polar organic solvent;

(c) simultaneously extruding at least one stream of said first aromatic poly(amic acid) solution from step (a) and at least one stream of said second poly(amic acid) solution from step (b) through an extrusion die onto the surface of a support, thereby forming at least two poly(amic acid) film layers;

(d) solidifying said poly(amic acid) film layers on said support by evaporating said organic polar solvent, thereby forming a self-supporting multi-layer film;

(e) removing said self-supporting multi-layer film from said support; and

(f) heat-treating said self-supporting multi-layer film to completely convert said first and second poly(amic acid) layers to said multi-layer polyimide film.

In a further embodiment of the invention, the first and the second solution streams of poly(amic acid)s in steps (a) and (b) may additionally contain fine particles of an inorganic filler.

## DETAILED DESCRIPTION OF THE INVENTION

The present invention relates to a multi-layer aromatic polyimide film comprising a polyimide base film layer and at least one layer of a heat-sealable polyimide film, prepared by coextruding first and second solution streams of poly(amic acid)s derived from the reaction of suitable aromatic tetracarboxylic dianhydrides and suitable diamines to form two or more layers of poly(amic acid) film, then drying and heat-treating to form the final multi-layered polyimide film structure.

The polyimide base film contains recurring imide units of the formula

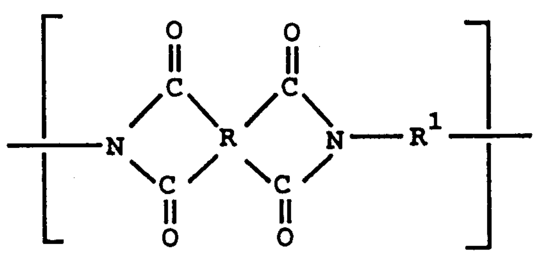

wherein R is a tetravalent aromatic radical containing at least one ring of six carbon atoms, the four carbonyl groups being directly attached to separate carbon atoms in a ring of the R radical and each pair of carbonyl groups being attached to adjacent carbon atoms in a ring of the R radical; and wherein $R^1$ is a divalent radical of an aromatic diamine.

Dianhydrides which can be used in the polyimide base film include:

pyromellitic dianhydride;

3,4,9,10-perylene tetracarboxylic dianhydride;

naphthalene-2,3,6,7-tetracarboxylic dianhydride;

napththalene-1,4,5,8-tetracarboxylic dianhydride;

bis(3,4-dicarboxyphenyl)ether dianhydride;

bis(3,4-dicarboxyphenyl)sulfone dianhydride;

2,3,2',3'-benzophenonetetracarboxylic dianhydride;

bis(3,4-dicarboxyphenyl)sulfide dianhydride;

bis(3,4-dicarboxyphenyl)methane dianhydride;

2,2-bis(3,4-dicarboxyphenyl)propane dianhydride;

2,2-bis(3,4-dicarboxyphenyl)hexafluoropropane dianhydride;

3,4,3',4'-biphenyltetracarboxylic dianhydride;
2,6-dichloronaphthalene-1,4,5,8-tetracarboxylic dianhydride;
2,7-dichloronaphthalene-1,4,5,8-tetracarboxylic dianhydride;
2,3,6,7-tetrachloronaphthalene-1,4,5,8-tetracarboxylic dianhydride;
phenanthrene-1,8,9,10-tetracarboxylic dianhydride; and benzene-1,2,3,4-tetracarboxylic dianhydride.

Diamines which can be used together with the dianhydrides in the polyimide base film include the following:

meta-phenylenediamine;
para-phenylenediamine;
2,2-bis(4-aminophenyl)propane;
4,4'-diaminodiphenylmethane;
4,4'-diaminodiphenyl sulfide;
4,4'-diaminodiphenyl sulfone;
3,3'-diaminodiphenyl sulfone;
4,4'-diaminodiphenyl ether;
3,4'-diaminodiphenyl ether;
2,6-diaminopyridine;
bis(3-aminophenyl)diethyl silane; benzidine;
3,3'-dichlorobenzidine;
3,3'-dimethoxybenzidine;
4,4'-diaminobenzophenone;
N,N-bis(4-aminophenyl)-n-butylamine;
N,N-bis(4-aminophenyl)methylamine;
1,5-diaminonaphthalene;
3,3'-dimethyl-4,4'-diaminobiphenyl;
m-aminobenzoyl-p-aminoanilide;
4-aminophenyl-3-aminobenzoate;
N,N-bis(4-aminophenyl)aniline;
2,4-bis(beta-amino-t-butyl)toluene;
bis(p-beta-amino-t-butylphenyl)ether;
p-bis-2-(2-methyl-4-aminopentyl)benzene;
p-bis(1,1-dimethyl-5-aminopentyl)benzene;
m-xylylenediamine;
p-xylylenediamine;
position isomers of the above, and mixtures thereof.

The preparation of the polyimides and poly(amic acid)s is more fully described in U.S. Patent No. 3,179,614 and U.S. Patent No. 3,179,634.

A particularly preferred polyimide base film is derived from 4,4'-diaminodiphenyl ether and pyromellitic dianhydride.

Copolyimides derived from any of the aforesaid tetracarboxylic dianhydrides and aromatic diamines can also be used as the polyimide base film layer. Particularly preferred copolyimides are those derived from 3,3',4,4'-biphenyltetracarboxylic dianhydride, pyromellitic dianhydride, p-phenylene diamine and 4,4'-diaminodiphenyl ether, such as are described in U.S. 5,166,308. The use of such copolyimides as the base layer is preferred from the viewpoint of low coefficient of thermal expansion, low water absorption, low coefficient of hygroscopic expansion and high mechanical strength of the resultant film.

The polyimide heat-sealable film contains from 30 to 100 mole %, preferably from 40 to 80 mole %, of recurring imide units derived from 4,4'-oxydiphthalic dianhydride and a (diaminophenoxy)benzene having the formula

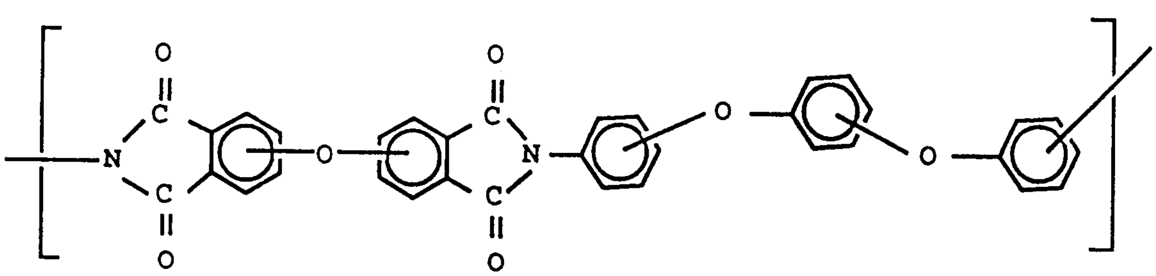

Suitable (diaminophenoxy)benzenes for use in the heat-sealable polyimide film include:

1,2-bis(4-aminophenoxy)benzene;
1,3-bis(4-aminophenoxy)benzene;
1,2-bis(3-aminophenoxy)benzene;
1,3-bis(3-aminophenoxy)benzene;
1-(4-aminophenoxy)-3-(3-aminophenoxy)benzene;
1,4-bis(4-aminophenoxy)benzene;
1,4-bis(3-aminophenoxy)benzene; and
1-(4-aminophenoxy)-4-(3-aminophenoxy)benzene.

The heat-sealable polyimide film may contain from 0 up to 30 mole %, preferably from 5 to 15 mole %, of additional recurring imide units derived from dianhydrides and diamines which are different from the 4,4'-oxydiphthalic dianhydride and the (diaminophenoxy)benzenes previously described. The polyimide thus obtained advantageously has a glass transition temperature of less than 250 °C which enhances affinity to the base polyimide layer and improves adhesion to metal foil without reducing the good thermal, mechanical and electrical properties of the resultant film.

Particularly preferred dianhydrides and diamines for use in the heat-sealable polyimide film include:

pyromellitic dianhydride;
3,3'4,4'-benzophenone tetracarboxylic dianhydride;
2,2',3,3'-benzophenone tetracarboxylic dianhydride;
3,3',4,4'-biphenyl tetracarboxylic dianhydride;
2,2',3,3'-biphenyl tetracarboxylic dianhydride;
2,2-bis(3,4-dicarboxyphenyl)hexafluoropropane dianhydride;
2,2-bis(3,4-dicarboxyphenyl)sulfone dianhydride;
2,2-bis(3,4-dicarboxyphenyl)sulfide dianhydride;
2,2-bis(2,3-dicarboxyphenyl)methane dianhydride;
2,2-bis(3,4-dicarboxyphenyl)methane dianhydride;
1,1-bis(2,3-dicarboxyphenyl)ethane dianhydride;
1,1-bis(2,3-dicarboxyphenyl)propane dianhydride;
2,2-bis(3,4-dicarboxyphenyl)propane dianhydride;
m-phenylene bis(trimellitate)dianhydride;
hexamethylene diamine;
heptamethylenediamine;
3,3-dimethylpentamethylenediamine;
3-methylhexamethylenediamine;
3-methylheptamethylenediamine;
2,5-dimethylhexamethylenediamine;
octamethylenediamine;
nonamethylenediamine;
1,1,6,6-tetramethylhexamethylenediamine;
2,2,5,5-tetramethylhexamethylenediamine;
4,4-dimethylheptamethylenediamine;
decamethylenediamine;
4,4'-diaminobenzophenone;
4-aminophenyl-3-aminobenzoate;
m-aminobenzoyl -p-aminoanilide;
4,4'-diaminodiphenylether;
3,4'-diaminodiphenylether;
bis(4-aminophenyl)methane;
1,1-bis(4-aminophenyl)ethane;
2,2-bis(4-aminophenyl)propane;
4,4'-diaminodiphenylsulfoxide;
3,3',-diaminobenzophenone;
2,2'-diaminobenzophenone;
1,3-bis(4-aminobenzoyloxy)benzene;
4,4'-diaminobenzanilide;
4,4'-bis(4-aminophenoxy)phenyl ether;
2,2'-bis(4-aminophenyl)hexafluoropropane;
2,2-bis(4-aminophenyl)-1,3-dichloro-1,1,3,3-tetrafluoropropane;

4,4'-diaminodiphenyl sulfone;
1,12-diaminododecane;
1,13-diaminotridecane; and
a polysiloxane diamine of the formula

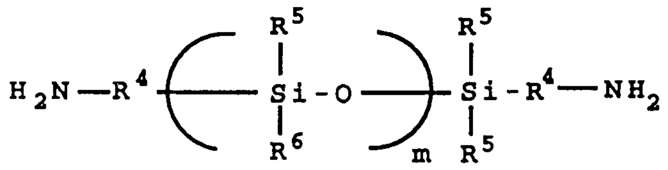

wherein $R_4$ is lower alkylene, aralkylene or phenylene, $R_5$ is lower alkyl or phenyl, $R_6$ is lower alkyl or phenyl and m is 1 to 100. The term "lower" includes from 1 to 3 carbon atoms.

The heat-sealable polyimide film is more fully described in European Patent Application 0 474 054.

Particularly preferred heat-sealable polyimide films for use in the multi-layer polyimide films of the invention contain from 70 to 95 mole % of 4,4'-oxydiphthalic dianhydride, 5 to 30 mole % of pyromellitic dianhydride and 100 mole % of 1,3-bis(4-aminophenoxy)benzene and from 70 to 95 mole % of 1,3-bis(4-aminophenoxy)benzene, 5 to 30 mole % of hexamethylene diamine, 70 to 90 mole % of 4,4'-oxydiphthalic dianhydride and 10 to 30 mole % of pyromellitic dianhydride.

Both the polyimide base film and the heat-sealable polyimide film can additionally contain inert inorganic or organic filler particles to improve slip or enhance other properties of the final multi-layer film. The additional filler can be selected from conventional inorganic fillers, such as silica, colloidal silica, titanium dioxide, calcium carbonate, magnesium oxide, alumina, calcium phosphates, carbon black, alumina silicate molecular sieves and the like.

For example, inorganic silica and calcium phosphate filler particles can be introduced into the outer heat-sealable polyimide film layers to enhance winding properties of the multi-layer film. Alumina particles can be introduced into the polyimide base film layer and the outer heat-sealable polyimide film layers to enhance thermal conductivity of the multi-layer film. Introduction of alumina particles into the polyimide film base layer also provides opacity and improves contrast of the multi-layer film. Carbon particles can be added to the polyimide base film layer and the outer heat-sealable polyimide film layers to improve electrical conductivity, oxidative thermal resistance, ultraviolet resistance and spectral absorption of the multi-layer film required for various end-uses. The filler particles have an average particle size of from 0.01 to 20 micrometers, preferably from 0.3 to 2 micrometers and are used in amounts of from 0.001% to 65% by weight based on the weight of the polyimide film layer in which the filler particles are introduced.

According to the process of the present invention, a first solution (a) of a poly(amic acid) dissolved in an organic polar solvent and a second solution (b) of a poly(amic acid) dissolved in a polar organic solvent are simultaneously fed to separate channels of a multicavity extrusion die or to different channels of a feedblock extrusion die. Optionally, filler particles can be introduced into one or both of the poly(amic acid) solutions. Subsequently, both of the poly(amic acid) solutions (a) and (b) are extruded continuously from the outlet of the die in the form of a composite thin film, having at least two layers, onto the surface of a revolving, heated Support, such as an endless metal belt.

The extruded multi-layer film is heated at a temperature of from 30 °C to 300 °C, preferably from 60 °C to 200 °C, for a sufficient time to dry and solidify the film on the support.

The self-supporting multi-layer film is then peeled from the support and heat-treated at from 200 °C to 600 °C, for from 0.1 to 120 minutes, depending on the temperature, to completely convert the poly(amic acid)s to the polyimides.

In the process of the invention, each of the first and second poly(amic acid) solutions (a) and (b) may be a poly(amic acid) solution comprising a poly(amic acid) derived from the aforementioned tetracarboxylic dianhydrides and diamines and an organic solvent. Typically, the poly(amic acid) solutions (a) and (b) are prepared by dissolving the diamine in the organic polar solvent and slowly adding the tetracarboxylic dianhydride under conditions of agitation and controlled temperature in an inert atmosphere. The diamine is conveniently present as a 5 to 15 weight % solution in the organic solvent and the diamine and dianhydride are usually used in about equimolar amounts. The poly(amic acid) solution preferably contains the poly-(amic acid) in an amount of from 5 to 40% by weight, preferably from 10 to 30% by weight, and has a solution viscosity in the range of from 0.01 to 10,000 poises, preferably from 100 to 3000 poises, at 30 °C.

The inherent viscosity of the poly(amic acid) ranges from 0.7 to 2.0, measured at 30°C at a concentration of 0.5 g/dl in N-dimethyl-acetamide solvent.

Examples of polar organic solvents that can be used in the poly(amic acid) solutions include N-methyl-2-pyrrolidone, N,N-dimethylacetamide, N,N-diethylacetamide, dimethylsulfoxide, N,N-dimethylformamide and N,N-diethylformamide, mixtures thereof, and mixtures with other cosolvents.

The thickness of the polyimide film base layer and the heat-sealable polyimide film layers in the coextruded multi-layer polyimide film can be controlled by adjusting the feed rates of poly(amic acid) solutions (a) and (b) to the film-forming die.

The total thickness of the coextruded multi-layer polyimide film generally ranges from 0.1 to 10.0 mils, preferably from 0.5 to 5.0 mils.

In the coextruded multi-layer polyimide film of the invention, heat-sealable polyimide film layers may be formed on one or both sides of the polyimide base film to provide either two- or three-layered polyimide films. Additionally, the multi-layer polyimide film may contain other coextruded filled or unfilled polyimide layers to provide advantageous properties to the multi-layer film. For example, a multi-layer polyimide film may comprise, in sequence, an outer layer of heat-sealable copolyimide derived from 4,4'-oxydiphthalic dianhydride, pyromellitic dianhydride and 1,3-bis(4-aminophenoxy)benzene, a copolyimide layer derived from 3,3',4,4'-biphenyltetracarboxylic dianhydride, pyromellitic dianhydride, 4,4'-diaminodiphenyl ether and p-phenylene diamine for imparting high modulus, an alumina filled polyimide layer derived from pyromellitic dianhydride and 4,4'-diaminodiphenyl ether for providing thermal conductivity and another outside heat-sealable polyimide layer filled with alumina to provide both thermal conductivity and bonding capability to the structure. Other coextruded multi-layer film structures will be readily apparent to the skilled artisan.

A preferred two-layer coextruded multi-layer polyimide film, prepared according to the process of the invention, has a total thickness of 1 mil, and comprises a polyimide base layer having a thickness of 0.5 mil, derived from pyromellitic dianhydride and 4,4'-diaminodiphenyl ether; and a polyimide heat-sealable layer, having a thickness of 0.5 mil, derived from 80 mole % of 4,4'-oxydiphthalic dianhydride, 20 mole % of pyromellitic dianhydride and 100 mole % of 1,3-bis(4-aminophenoxy)benzene.

A preferred three-layer coextruded multi-layer polyimide film, prepared according to the process of the invention, has a total thickness of 2 mils, and comprises a polyimide base layer having a thickness of 1.4 mils, derived from 92 mole % of 3,3',4,4'-biphenyltetracarboxylic dianhydride, 8 mole % of pyromellitic dianhydride, 95 mole % of p-phenylene diamine and 5 mole % of 4,4'-diaminodiphenyl ether; and outer heat-sealable polyimide layers, each having a thickness of 0.3 mil, derived from 80 mole % of 4,4'-oxydiphthalic dianhydride, 20 mole % of pyromellitic dianhydride and 100 mole % of 1,3-bis(4-aminophenoxy)benzene. This multi-layer film has a low thermal expansion coefficient, high modulus and good dimensional stability; can be metallized or directly bonded to various substrates to make high performance laminates; and has excellent adhesion, electrical properties, thermal durability, and chemical and radiation resistance properties. Such a multi-layer film is suitable for use in high performance applications such as metal clads, polyimide covercoat/bondply for flexible printed circuits and tape automated bonding, all polyimide multi-layer printed wiring boards, heater circuits, sensors, ceramic-polyimide systems for multi-chip modules, heat sinks, advanced composite constructions, thick polyimide film laminates and in high performance parts.

The coextruded multi-layer polyimide films prepared according to the process of the invention can be used to form single and double polyimide metal-clad laminates for use in flexible circuit applications. The single polyimide metal-clads are prepared by laminating a heat-sealable polyimide layer of the multi-layer polyimide to a metal foil such as copper, aluminum, nickel, steel or an alloy containing one or more of these metals or to a foil of amorphous metal. The polyimide layer adheres firmly to the metal and has a peel strength of 6 pli or higher. Particularly suitable metallic substrates are foils of rolled, annealed or electro-deposited copper or rolled annealed copper alloy. In some cases, it has proved to be of advantage to pretreat the metal foil substrate. The pretreatment can consist of a chemical treatment or a mechanical roughening treatment which can further increase the peel strength.

Similarly, a double side polyimide metal-clad can be prepared by laminating metal foils to both outer heat-sealable polyimide layers of the multi-layer polyimide.

Lamination of the metal foil to the coextruded multi-layer polyimide film can be preformed by combining the metal foil and the multi-layer polyimide film without using an adhesive and heat-pressing using a pressure ranging from 10 to 50 kg/cm$^2$, preferably from 20 to 30 kg/cm$^2$, and a temperature ranging from 200°C to 400°C, preferably from 250°C to 350°C, for from 10 seconds to 60 minutes.

The particular advantage of the coextruded multi-layer polyimide metal-clad laminates, prepared according to the invention, over those of the prior art is that the adhesive strength between the polyimide layers is markedly improved, causing adhesive failure to occur primarily at the interface between the metal

and the heat-sealable polyimide layer and not between adjacent polyimide layers. Presumably, the increased adhesion is due to the partial solubility of each poly(amic acid) polymer in the adjacent layer of poly(amic acid) polymer which allows the polymers to diffuse across the boundary between the layers and results in intermingling of the polymer chains across the boundary after curing. The penetration, or diffusion, results in more extensive contact and bonding between the layers, which is lacking in prior art multi-layer polyimide films.

The advantageous properties of this invention can be observed by reference to the following examples which illustrate, but do not limit, the invention. All parts and percentages are by weight unless otherwise indicated.

GLOSSARY

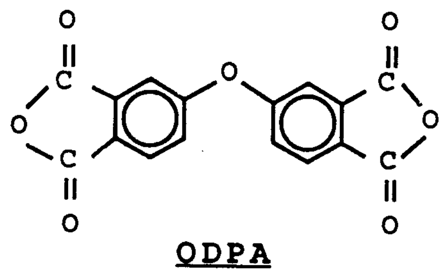

ODPA

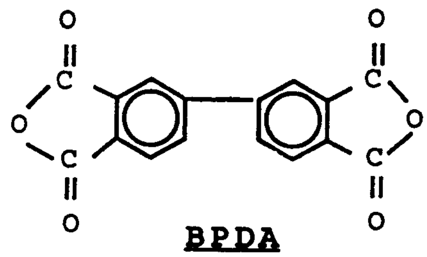

BPDA

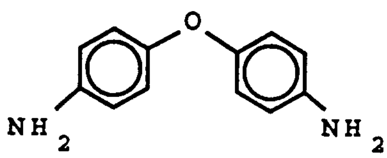

ODA

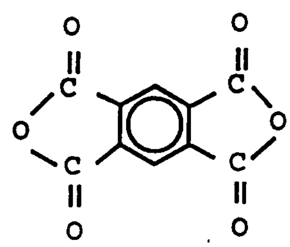

PMDA

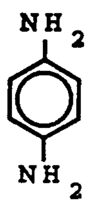

PPD

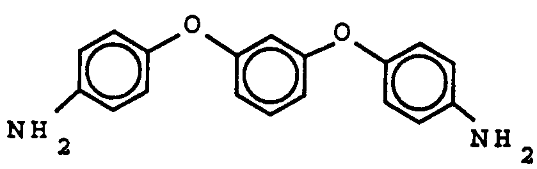

134APB

$H_2N-(CH_2)_6-NH_2$

HMDA

The tests for evaluating the coextruded multi-layer films produced in the examples were conducted as follows:

1. Tensile strength, elongation and elastic modulus were measured using ASTM D-882.
2. Adhesive strength of metal laminated film was measured using IPC Method TM-2.4.9.
3. Elmendorf tear strength was measured using ASTM D-1922-61T.
4. MIT fold endurance was measured using ASTM-D-2176-69.
5. Dielectric strength was measured using ASTM-149-81.
6. Dielectric constant was measured using ASTM-D-150-81.
7. Volume resistivity was measured using ASTM D-257-78 (1983).
8. Coefficient of thermal expansion was determined by measuring the thermal expansion of a film sample over the temperature range of 50 °C to 250 °C on the second pass on a dilatometer.
9. Radius of curl was measured by measuring the diameter of the curled film and dividing by 2 or by using the equation

$$r = \left(\frac{w2}{8h}\right) + \frac{h}{2}$$

where w = length of curl and h = height of curl.

10. Thickness was measured using a Mitutoyo micrometer (No. 1519-615-1).

11. Longitudinal and transverse $F_3$ (stress at 3% elongation) was measured using ASTM-D-882-81.

EXAMPLES 1 TO 3

These examples illustrate the preparation of 1.0, 2.0 and 5.0 mils thick coextruded, two-layer polyimide films according to the invention.

Pyromellitic dianhydride (PMDA) AND 4,4'-diamino-diphenyl ether (ODA) were polymerized in N,N-dimethyl-acetamide (DMAC) solvent to give a first aromatic poly(amic acid) solution having a polymer content of 20% by weight and a solution viscosity of approximately 1000 poises.

Separately, 80 mole % of 4,4'-oxydiphthalic dianhydride (ODPA), 20 mole % of pyromellitic dianhydride (PMDA) and 100 mole % of 1,3-bis(4-aminophenoxy)benzene (134APB) were polymerized in DMAC solvent to give a second poly(amic solution) having a polymer content of 20% by weight.

Streams of the first and second poly(amic acid) solutions were simultaneously extruded through a multi-cavity extrusion die onto the surface of a heated moving belt to form a coextruded two-layer film. The thicknesses of the two layers were changed by varying the feed rates of the two poly(amic acid) solutions to the extrusion die. The bottom layer next to the belt comprised the PMDA/ODA polymer and the top or air side layer comprised the 80 mole % ODPA/20 mole % PMDA/100 mole % 134APB polymer.

The extruded film was continuously dried at temperatures from 35° to 180°C to give a self-supporting film containing about 14.4 weight % of solvent. The solid film was peeled from the belt support and treated with radiant heat in a radiant tenter oven at heater surface temperatures between 125°C to 770°C for from 10 minutes to 25 minutes to completely dry and imidize the polymers. The properties of the final coextruded two-layer polyimide films are summarized in Table I.

The heat-sealable polyimide side of the two-layer film was placed in contact with a copper foil having a thickness of 35 micrometers and the composite was heat-pressed between heating plates at a temperature of 350°C and under a pressure of 25 $kg/cm^2$ for 30 minutes to form a laminate of the polyimide with the copper foil. Adhesive strengths are given in Table I.

TABLE I

| COEXTRUDED TWO-LAYER POLYIMIDE FILM (A/H FILM) * | | | |
|---|---|---|---|
| PROPERTY | EX. 1 .50A/.50H | EX. 2 .50A/1.5OH | EX. 3 .50A/4.5OH |
| TOTAL THICKNESS, MILS | 1.08 | 1.94 | 5.38 |
| A-LAYER THICKNESS | 0.54 | 0.48 | 0.54 |
| H-LAYER THICKNESS | 0.54 | 1.46 | 4.84 |
| RADIUS OF CURL, inch | 0.50 | 2.0 | 2.0 |
| % DMAC | 0.28 | 0.01 | 0.15 |
| DENSITY, g/cc | 1.3916 | 1.4038 | 1.4138 |
| MD MODULUS, kpsi | 330 | 340 | 300 |
| TD MODULUS, kpsi | 350 | 290 | 260 |
| MD TENSILE, kpsi | 17.7 | 30.2 | 23.8 |
| TD TENSILE, kpsi | 16.5 | 23.2 | 18.2 |
| MD ELONGATION, % | 47 | 121 | 142 |
| TD ELONGATION, % | 58 | 122 | 160 |
| MD $F_3$, kpsi | 8.52 | 7.89 | 7.23 |
| TD $F_3$, kpsi | 8.22 | 7.06 | 6.49 |
| MD TEAR, g/mil | 4.61 | 7.15 | 14.6 |
| TD TEAR g/mil | 5.19 | 5.14 | 21.2 |
| MD MIT FOLD, cycles | 256,000 | 61,900 | 638 |
| TD MIT FOLD, cycles | 444,000 | 74,900 | 587 |
| MD CTE, ppm/°C | ------ | ------ | 48 |
| TD CTE, ppm/°C | ------ | ------ | 60 |
| VOLUME RESISTIVITY, ohm-cm | $1.21X10^{17}$ | $2.50X10^{17}$ | ---- |
| DIELECTRIC STRENGTH, v/mil | 4820 | 5740 | 3820 |
| DIELECTRIC CONSTANT, lkc | 3.58 | 3.63 | 3.85 |
| DISSIPATION FACTOR, lkc | .0016 | .0013 | .0017 |
| ADHESIVE STRENGTH, pli | 8.0 | 6.6 | 10.0 |

*Layer A = 80 mole % ODPA/20 mole % PMDA/100 mole % 134APB
Layer H = 100 mole % PMDA/100 mole % ODA

EXAMPLES 4 TO 8

These examples illustrate the preparation of 1.0, 1.5, 2.0, 3.0 and 4.0 mils thick coextruded three-layer polyimide films according to the invention.

Coextruded three-layer polyimide films having a PMDA/ODA polyimide core layer and top and bottom layers of 80 mole % ODPA/20 mole % PMDA/100 mole % 134APB heat-sealable polyimide were prepared as described in Examples 1 to 3.

Three separate poly(amic acid) polymer streams were simultaneously extruded through a multi-cavity extrusion die onto a heated moving belt to form a coextruded three-layer polyimide film. The thickness of the polyimide core layer and the top and bottom heat-sealable polyimide layers was adjusted by varying the amounts of poly(amic acid)s fed to the extruder. The top and bottom layers had the same thickness so that the multi-layer construction was symmetric and had no curl.

The extruded film was dried at 95° to 150°C on a moving belt to give a self-supporting film having a solvent content of 18.6 weight %.

The self-supporting film was peeled from the belt and heated with radiant heat in a tenter oven at from 110°C to 770°C (radiant heater surface temperature) for from 11 minutes to 33 minutes to completely dry and imidize the polymers.

The properties of the final coextruded three-layer polyimide films are summarized in Table II. Depending on the relative thickness of the outer heat-sealable polyimide layers, the multi-layer films can be used as metal-clad laminates (Example 6, .50A/1.0H/.50A), bondply sheets (Example 7, 1.5A/1.0H/1.5A) or as wire insulation (Example 8, .20A/.60H/.20A).

TABLE II

| COEXTRUDED THREE-LAYER POLYIMIDE FILM (A/H/A FILM)* | | | | | |
|---|---|---|---|---|---|
| PROPERTY | EX. 4 .50A/.50H/.50A | EX. 5 1.00A/1.00H/1.00A | EX. 6 .50A/1.00H/.50A | EX. 7 1.50A/1.00H/1.50A | EX. 8 .20A/.60H/.20A |
| TOTAL THICKNESS, mils | 1.55 | 3.25 | 2.09 | 4.48 | 1.15 |
| TOP A-LAYER THICK | 0.51 | 1.08 | 0.52 | 1.68 | 0.23 |
| CORE H-LAYER THICK | 0.53 | 1.09 | 1.05 | 1.12 | 0.69 |
| BOTTOM A-LAYER THICK | 0.51 | 1.08 | 0.52 | 1.68 | 0.23 |
| % DMAc | 0.35 | 0.46 | 0.38 | 0.39 | 0.08 |
| DENSITY, g/cc | 1.3784 | 1.3789 | 1.3876 | 1.3778 | 1.3921 |
| MD MODULUS, kpsi | 410 | 360 | 380 | 340 | 380 |
| TD MODULUS, kpsi | 390 | 390 | 360 | 330 | 370 |
| MD TENSILE, kpsi | 21.0 | 22.9 | 21.6 | 18.6 | 29.5 |
| TD TENSILE, kpsi | 20.0 | 23.3 | 18.9 | 17.0 | 26.6 |
| MD ELONGATION, % | 94 | 138 | 92 | 104 | 113 |
| TD ELONGATION, % | 95 | 140 | 96 | 89 | 119 |
| MD TEAR, g/mil | 9.8 | 15.4 | 7.2 | 18.6 | 4.85 |
| TD TEAR, g/mil | 9.4 | 16.0 | 8.7 | 21.2 | 4.90 |
| MD MIT FOLD, cycles | ---- | ---- | 46300 | 354 | ---- |
| TD MIT FOLD, cycles | ---- | ---- | 40300 | 296 | ---- |
| MD CTE, ppm/°C | 53.8 | 60.0 | 54.7 | 58.0 | 44.0 |
| TD, CTE, ppm/°C | 60.3 | 69.0 | 65.1 | 67.8 | 50.8 |
| DIELECTRIC STRENGTH, V/mil | 6000 | 3900 | 5040 | 3100 | 7400 |
| DIELECTRIC CONSTANT, lkc | 3.54 | 3.64 | 3.58 | 3.62 | 3.48 |
| DISSIPATION FACTOR, lkc | .0017 | .0018 | .0015 | .0018 | .0013 |
| VOLUME RESISTIVITY, ohm-cm | $4.3X10^{16}$ | $3.3X10^{16}$ | $1.8X10^{17}$ | $1.0X10^{17}$ | ---- |

| | | | | | |
|---|---|---|---|---|---|
| ADHESIVE STRENGTH, pli** | 13.0/13.0 | 12.0/12.0 | 12.2/12.0 | 11.6/12.4 | 12.0/11.6 |

*Layer A = 80 mole % ODPA/20 mole % PMDA/100 mole % 134APB Layer H = 100 mole % PMDA/100 mole % ODA
**Top/bottom

EXAMPLE 9

A coextruded, 2.0 mil thick three-layer polyimide film was prepared as described in Examples 4 to 8, except that a 15 weight % solution of a poly(amic acid) prepared by polymerization of 92 mole % of BPDA, 8 mole % of PMDA, 95 mole % of PPD and 5 mole % of ODA was used as the first poly(amic acid) solution stream. Calcium hydrogen phosphate (3000 ppm) was added to the polymer stream as a slip additive.

The three polymer streams were fed to a multi-cavity extrusion die and extruded onto a moving belt to form a three-layer coextruded polyimide film. The extruded film was dried at a temperature of from 110° to 230°C and finally heated in a tenter oven using radiant heat at a radiant surface temperature of from 250°C to 720°C.

The properties of the three-layer polyimide film are summarized in Table III. The film exhibited very high modulus (>750 kpsi), a low CTE of 22 ppm/°C and an adhesion of over 14 pli when bonded on both sides to copper foil.

TABLE III

| PROPERTIES OF THREE-LAYER, COEXTRUDED POLYIMIDE FILM (A/E/A FILM)* | |
|---|---|
| PROPERTY | EX. 9 .30A/1.40E/.30A |
| TOTAL THICKNESS, MILS | 2.00 |
| MD MODULUS, kpsi | 750. |
| TD MODULUS, kpsi | 770. |
| MD TENSILE, kpsi | 50.5 |
| TD TENSILE, kpsi | 53.5 |
| MD ELONGATION, % | 63. |
| TD ELONGATION, % | 70. |
| MD $F_3$, kpsi | 18.4 |
| TD $F_3$, kpsi | 18.8 |
| MD MIT FOLD, cycles | 121,000. |
| TD MIT FOLD, cycles | 149,000. |
| MD CTE, ppm/°C | 22.0 |
| TD CTE, ppm/°C | 22.8 |
| % DMAc | 0.004 |
| DENSITY, gm/cc | 1.4372 |
| ADHESIVE STRENGTH, pli | 15.5/14.4** |

*Layer A = 80 mole % ODPA/20 mole % PMDA/100 mole % 134APB
Layer E = 92 mole % BPDA/8 mole % PMDA/95 mole % PPD/5 mole % ODA containing 3000 ppm of calcium hydrogen phosphate.
**top/bottom

EXAMPLE 10

A coextruded, 1.2 mils thick three-layer polyimide film was prepared as described in Examples 4 to 8, except that a 20% by weight solution of a poly(amic acid) prepared by polymerization of BPDA and PPD was used as the first poly(amic acid) solution stream. The multi-cavity die was fed with three poly(amic acid) polymer streams wherein the center stream was the BPDA/PPD poly(amic acid) stream and the

outside streams were both 80 mole % ODPA/20 mole % PMDA/100 mole % 134APB poly(amic acid) streams. All three streams were run at the same throughput so as to give an average layer thickness ratio of 1:1:1. The coextruded film was cast on a heated belt running at about 1.5 fpm. The film was dried at temperatures up to 150 °C, removed from the belt and finally heated in a tenter oven using radiant heat at temperatures of from 120 °C to 773 °C. The final coextruded three-layer polyimide film had a modulus of 450 kpsi in both directions and an elongation of 93% in the MD direction and 69% in the TD direction.

EXAMPLES 11 TO 13

Coextruded two- and three-layer polyimide films were prepared as described in Examples 1 to 3 and in Examples 4 to 8, respectively. A 20 weight % solution of a poly(amic acid) prepared by polymerization of PMDA and ODA was used as the first poly(amic acid) solution stream and a 20 weight % solution of a poly-(amic acid) prepared by polymerization of 80 mole % of ODPA, 20 mole % of PMDA, 82 mole % of 134APB and 18 mole % of HMDA was used as the second poly(amic acid) solution stream.

The polymer streams were fed to a multi-cavity extrusion die and extruded onto a moving belt to form either a two-layer (Examples 11 and 12) or three-layer (Example 13) polyimide film. The extruded films were dried at a temperature of from 90 °C to 154 °C and then heated in a tenter oven using radiant heat at a radiant surface temperature of from 110 °C to 606 °C for from 12 to 15 minutes.

The properties of the resulting two- and three-layer polyimide films are summarized in Table IV.

TABLE IV

| PROPERTIES OF MULTI-LAYER, COEXTRUDED POLYIMIDE FILMS* | | | |
|---|---|---|---|
| PROPERTY | EXAMPLE 11 0.50B/1.50H | EXAMPLE 12 0.50B/0.50H | EXAMPLE 13 0.50B/1.00H/0.50B |
| TOTAL THICKNESS, MILS | 2.19 | 1.15 | 2.06 |
| MD MODULUS, Kpsi | 350 | 370 | 390 |
| TD MODULUS, Kpsi | 320 | 390 | 390 |
| MD TENSILE, Kpsi | 26 | 21 | 18 |
| TD TENSILE, Kpsi | 20 | 22 | 19 |
| MD ELONGATION, % | 124 | 89 | 87 |
| TD ELONGATION, % | 122 | 108 | 123 |
| MD CTE, ppm/ °C | 52 | 50 | 56 |
| TD CTE, ppm/ °C | 72 | 58 | 68 |
| DIELECTRIC STRENGTH, V/mil | 4370 | 6360 | 4860 |
| % DMAC | 0.26 | 0.24 | 1.0 |
| DENSITY, gm/cc | 1.3988 | 1.3880 | 1.3890 |
| ADHESIVE STRENGTH, pli | 8.0 | 6.8 | 14.4/14.0** |

*Layer B = 80 mole % ODPA/20 mole % PMDA/82 mole % 134APB/18 mole % HMDA
Layer H = 100 MOLE % PMDA/100 mole % ODA
**Top/bottom

**Claims**

1. A process for preparing a coextruded multi-layer aromatic polyimide film comprising the steps of:
   (a) forming a first solution stream of an aromatic poly(amic acid) derived from the reaction of at least one aromatic tetracarboxylic dianhydride and at least one aromatic diamine dissolved in a polar organic solvent;
   (b) forming a second solution stream of a poly(amic acid) derived from the reaction of from 30 to 100 mole % of 4,4'-oxydiphthalic dianhydride, from 0 to 30 mole % of an aromatic tetracarboxylic dianhydride selected from the group consisting of pyromellitic dianhydride, 3,3',4,4'-benzophenone tetracarboxylic dianhydridc, 2,2',3,3'-benzophenone tetracarboxylic dianhydride, 3,3',4,4'-biphenyltetracarboxylic dianhydride, 2,2',3,3'-biphenyltetracarboxylic dianhydride, 2,2-bis(3,4-dicarboxyphenyl)hexafluoropropane dianhydride, 2,2-bis(3,4-dicarboxyphenyl)sulfone dianhydride, 2,2-bis(3,4-dicarboxyphenyl)methane dianhydride, 2,2-bis(3,4-dicarboxyphenyl)propane dianhydride, and m-phenylene bis(trimellitate)dianhydride, from 30 to 100 mole % of a (diaminophenoxy)benzene of the formula

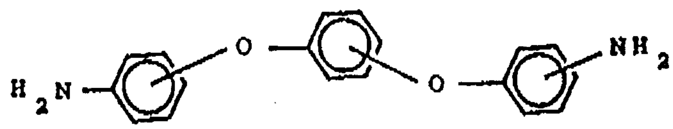

and from 0 to 30 mole % of a diamine selected from the group consisting of p-phenylene diamine, hexamethylene diamine, heptamethylene diamine, octamethylene diamine, 4,4'-diaminodiphenyl ether, 3,4'-diaminodiphenyl ether, 1,3-bis(4-aminobenzoyloxy)benzene, 4,4'-diaminobenzanilide, 4,4'-bis(4-aminophenoxy)phenyl ether and a polysiloxane diamine dissolved in said polar organic solvent;
(c) simultaneously extruding at least one stream of said first aromatic poly(amic acid) solution from step (a) and at least one stream of said second poly(amic acid) solution from step (b) through an extrusion die onto the surface of a support, thereby forming at least two poly(amic acid) film layers;
(d) solidifying said poly(amic acid) film layers on said support by evaporating said organic polar solvent, thereby forming a self-supporting multi-layer film;
(e) removing said self-supporting multi-layer film from said support, and
(f) heat-treating said self-supporting multi-layer film to completely convert said first and second poly-(amic acid) layers to said multi-layer polyimide film.

**2.** The process of Claim 1 wherein said first poly(amic acid) of step (a) comprises the reaction product of pyromellitic dianhydride and 4,4'-diaminodiphenyl ether.

**3.** The process of Claim 2 wherein said second poly(amic acid) of step (b) comprises the reaction product of from 70 to 95 mole % of 4,4'-oxydiphthalic dianhydride, from 5 to 30 mole % of pyromellitic dianhydride and 100 mole % of 1,3-bis(4-aminophenoxy)benzene.

**4.** The process of Claim 2 wherein said second poly(amic acid) poly(amic acid) of step (b) comprises the reaction product of from 70 to 95 mole % of 1,3-bis(4-aminophenoxy)benzene, from 5 to 30 mole % of hexamethylene diamine, from 70 to 90 mole % of 4,4'-oxydiphthalic dianhydride and from 10 to 30 mole % of pyromellitic dianhydride.

**5.** The process of Claim 2 wherein said second poly(amic acid) of step (b) comprises the reaction product of 100 mole % of 4,4'-oxydiphthalic dianhydride, from 70 to 95 mole % of 1,3-bis(4-aminophenoxy)-benzene and from 5 to 30 mole % of p-phenylene diamine.

**6.** The process of Claim 4 wherein said first and second streams of poly(amic acid) solution are extruded in step (c) into a two-layer film.

**7.** The process of Claim 4 wherein said first and second streams of poly(amic acid) solution are extruded in step (c) into a three-layer film.

**8.** A process for preparing a coextruded multi-layer aromatic polyimide film laminated with a metal foil comprising the steps of:
(a) forming a first solution stream of an aromatic poly(amic acid) derived from the reaction of at least one aromatic tetracarboxylic dianhydride and at least one aromatic diamine dissolved in a polar organic solvent;
(b) forming a second solution stream of a poly(amic acid) derived from the reaction of from 30 to 100 mole % of 4,4'-oxydiphthalic dianhydride, from 0 to 30 mole % of an aromatic tetracarboxylic dianhydride selected from the group consisting of pyromellitic dianhydride, 3,3',4,4'-benzophenone tetracarboxylic dianhydride, 2,2',3,3'-benzophenone tetracarboxylic dianhydride, 3,3',4,4'-biphenyltetracarboxylic dianhydride, 2,2',3,3'-biphenyltetracarboxylic dianhydride, 2,2-bis(3,4-dicarboxyphenyl)hexafluoropropane dianhydride, 2,2-bis(3,4-dicarboxyphenyl)sulfone dianhydride, 2,2-bis(3,4-dicarboxyphenyl)methane dianhydride, 2,2-bis(3,4-dicarboxyphenyl)propane dianhydride, and m-phenylene bis(trimellitate)dianhydride, from 30 to 100 mole % of a (diaminophenoxy)benzene of

the formula

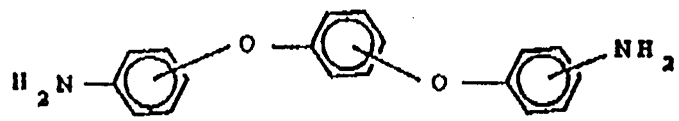

and from 0 to 30 mole % of a diamine selected from the group consisting of p-phenylene diamine, hexamethylene diamine, heptamethylene diamine, octamethylene diamine, 4,4'-diaminodiphenyl ether, 3,4'-diaminodiphenyl ether, 1,3-bis(4-aminobenzoyloxy)benzene, 4,4'-diaminobenzanilide, 4,4'bis(4-aminophenoxy)phenyl ether and a polysiloxane diamine dissolved in said polar organic solvent;

(c)simultaneously extruding at least one stream of said first aromatic poly(amic acid) solution from step (a) and at least one stream of said second poly(amic acid) solution from stop (b) through an extrusion die onto the surface of a support, thereby forming at least two poly(amic acid) film layers;

(d) solidifying said poly(amic acid) film layers on said support by evaporating said organic polar solvent, thereby forming a self-supporting multi-layer film;

(e) removing said self-supporting multi-layer film from said support;

(f) heat-treating said self-supporting multi-layer film to completely convert said first and second poly(amic acid) layers to said multi-layer polyimide film, and

(g) laminating a metal foil directly to at least one side of said multi-layer polyimide film from step (f) without using an adhesive and heat-pressing at a temperature of from 200 °C to 400 °C and under a pressure of from 10 to 50 kg/cm$^2$, wherein the adhesive strength of the metal foil to the multi-layer film is at least 6 pli as determined by IPC Method TM 2.4.9.

European Patent Office

# EUROPEAN SEARCH REPORT

Application Number
EP 94 11 9281

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,Y | EP-A-0 431 636 (UBE INDUSTRIES LTD.)<br>* page 4, line 35 - page 5, line 45 * | 1,2 | B32B27/34 |
| Y | DATABASE WPI<br>Week 9324,<br>Derwent Publications Ltd., London, GB;<br>AN 93-191732<br>& JP-A-5 117 596 (SUMITOMO BAKELITE CO.)<br>14 May 1993<br>* abstract * | 1,2 | |
| A | EP-A-0 353 094 (UBE INDUSTRIES LTD.)<br>* example 1 * | 1,2 | |
| A | EP-A-0 498 898 (CHISSO CORPORATION)<br>* claim 1 *<br>* page 5, line 35 - line 40 *<br>* page 9, line 12 - page 10, line 35 * | 1 | |
| A | EP-A-0 459 452 (UBE INDUSTRIES LTD.)<br>* claim 7 * | 8 | TECHNICAL FIELDS SEARCHED (Int.Cl.6) |
| A | US-A-4 788 098 (SADO ET AL.) | | B32B<br>C08G |

The present search report has been drawn up for all claims

| Place of search | Date of completion of the search | Examiner |
|---|---|---|
| THE HAGUE | 28 February 1995 | McConnell, C |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)